# EUROPÄISCHE PATENTSCHRIFT

(11) **EP 0 775 348 B1**
(45) Veröffentlichungstag und Bekanntmachung des Hinweises auf die Patenterteilung: **21.10.1998**
(21) Anmeldenummer: 95927639.5
(22) Anmeldetag: 07.08.1995
(51) Int. Cl.: G06F 19/00, G06F 7/00

(54) **VERFAHREN ZUR ERKENNUNG VON SIGNALEN MITTELS FUZZY-KLASSIFIKATION**
METHOD OF DETECTING SIGNALS BY MEANS OF FUZZY-LOGIC CLASSIFICATION
PROCEDE DE DETECTION DE SIGNAUX PAR CLASSIFICATION EN LOGIQUE FLOUE

(30) Priorität: 12.08.1994 DE 4428658
(43) Veröffentlichungstag der Anmeldung: 28.05.1997
(73) Patentinhaber: SIEMENS AKTIENGESELLSCHAFT, 80333 München (DE)
(72) Erfinder: PALM, Rainer, D-80331 München (DE)
(86) Internationale Anmeldenummer: DE9501033
(87) Internationale Veröffentlichungsnummer: WO9605565

(56) Entgegenhaltungen:
- US-A- 5 000 188
- AUTOMATISIERUNGSTECHNIK - AT, Bd. 42, Nr. 3, März 1994 MUNCHEN DE, Seiten 118-123, XP 000435853 H. FRANKE 'parallel-FUCS: Einsatzsystem zur On-line- und Real-time- Fuzzy-Klassifikation'
- FUZZY SETS AND SYSTEMS, Bd. 44, Nr. 3, 16.Dezember 1991 Seiten 421-430, XP 000258441 MARIN R ET AL 'ON KNOWLEDGE-BASED FUZZY CLASSIFIERS: A MEDICAL CASE STUDY'

## Beschreibung

Die Erfindung betrifft ein Verfahren zur Erkennung von Signalen mittels Fuzzy-Klassifikation. Derartige Verfahren werden in unterschiedlich Gebieten der Technik zur Regelung komplexer Systeme benötigt. Zur Regelung eines komplexen Systems gehört neben der Systemanalyse auch die Signalanalyse, um aus der Kenntnis über das Signal Schlußfolgerungen für einen Steuereingriff ziehen zu können. Häufig genügen nicht immer nur ausgewählte Signalparameter, sondern es sollte die Signalform in möglichst komplexer Weise bewertet werden können.

Aus der US-Patentschrift US-A-5 000 188 ist es bekannt Kurven von Blutdruckverläufen zu klassifizieren, um das Alter von Personen zu bestimmen. Hierzu wird der Blutdruckverlauf einer bestimmten Person ermittelt und mit repräsentativen Kurvenverläufen von bestimmten Altersgruppen verglichen, indem zwischen den Kurven ein Korrelationsmaß bestimmt wird, wodurch diejenige Kurve aus der Menge der Referenzkurven ermittelt wird, welche der aktuellen Kurve der Testperson am ähnlichsten ist. Aus dem Alter der Referenzgruppe wird dann auf das Alter der Testperson geschlossen. Weitere Klassifizierungsmethoden für Kurven sind nicht bekannt.

Der Erfindung liegt die Aufgabe zugrunde, ein Verfahren zur Erkennung von Signalen mittels Fuzzy-Klassifikation anzugeben, welches den eingangs genannten Anforderungen genügt. Diese Aufgabe wird erfindungsgemäß durch ein Verfahren zur Erkennung von Signalen mittels Fuzzy-Klassifikation mit Merkmalen nach Anspruch 1 gelöst. Dazu wird ein Signalkatalog aufgenommen, mit dem ein zu identifizierendes Signal verglichen wird. Dieser Katalog kann durch eine Trainingsphase aufgenommen werden oder durch das Mitwirken eines Experten entstehen. Zur Feststellung signifikanter Unterschiede wird ein geeignetes Abstandsmaß verwendet. Es werden demgemäß nur solche Signale in den Signalkatalog aufgenommen, die sich entsprechend diesem Maß unterscheiden. Gemäß der Erfindung wird ein auftretendes Signal zeitlich äquidistant abgetastet, und die Amplituden der Abtastwerte werden mit äquidistanten Schwellwerten verglichen. Den äquidistanten Schwellwerten werden dreiecksförmige Zugehörigkeitsfunktionen zugeordnet, die in dem betrachteten Intervall gleichverteilt sind. Dem zu identifizierenden Satz von Mustersignalen wird stets der gleiche Satz von Zugehörigkeitsfunktionen zugeordnet. Für ein ausgewähltes Mustersignal werden für die Abtastzeitwerte Zugehörigkeitswerte aus den Zugehörigkeitsfunktionen für die Schwellwerte bestimmt. Für jeden Abtastzeitpunkt wird ein Satz von Regeln definiert, der sämtliche Mustersignale charakterisiert. Diese Regeln geben an, zwischen welchen Schwellwerten das entsprechende Mustersignal zum betrachteten Abtastzeitpunkt liegt. Ein unbekanntes Signal wird dann dadurch klassifiziert, daß die Stärke für jede Regel durch Fuzzifizierung der Amplitudenwerte festgestellt wird und daß für jede Signalklasse die mittlere Stärke berechnet wird. Ein unbekanntes Signal wird derjenigen Signalklasse zugeordnet, für die die höchste Zugehörigkeit erreicht ist.

Figur 1 zeigt in schematischer Weise getastete Mustersignale mit Schwellwerten.

Figur 2 zeigt in schematischer Weise Zugehörigkeitsfunktionen für eine Signal Sl aus einem einfachen Beispiel zur Erläuterung des erfindungsgemäßen Verfahrens.

Figur 3 zeigt in schematischer Weise Zugehörigkeitsfunktionen für ein Signal S2 aus einem einfachen Beispiel zur Erläuterung des erfindungsgemäßen Verfahrens.

Im folgenden wird die Erfindung anhand bevorzugter Ausführungsbeispiele und mit Hilfe der Figuren näher beschrieben.

Zur Regelung eines komplexen Systems gehört neben der Systemanalyse auch die Signalanalyse, um aus der Kenntnis über das Signal Schlußfolgerungen für einen Steuereingriff ziehen zu können. Häufig genügen nicht immer nur ausgewählte Signalparameter, sondern es sollte die Signalform in möglichst komplexer Weise bewertet werden können.

Das vorliegende Verfahren trifft dabei die folgenden Voraussetzungen:
- Die zu identifizierenden Signale sollen sich signifikant unterscheiden.
- Das zu identifizierende Signal soll einem Mustersignal entsprechen.
- Die zu identifizierenden Signale sollen hinreichend glatt sein.

Es wird dann ein Signalkatalog aufgenommen, mit dem ein zu identifizierendes Signal verglichen wird. Dieser Katalog kann durch eine Trainingsphase aufgenommen werden oder durch das Mitwirken eines Experten entstehen. Zur Feststellung signifikanter Unterschiede wird ein geeignetes Abstandsmaß verwendet. Es werden demgemäß nur solche Signale in den Signalkatalog aufgenommen, die sich entsprechend diesem Maß unterscheiden. Ein Signal wird ferner als hinreichend glatt angesehen, wenn zwischen zwei Abtastzeitpunkten kein Wechsel in der Änderungsgeschwindigkeit des Signals erfolgt.

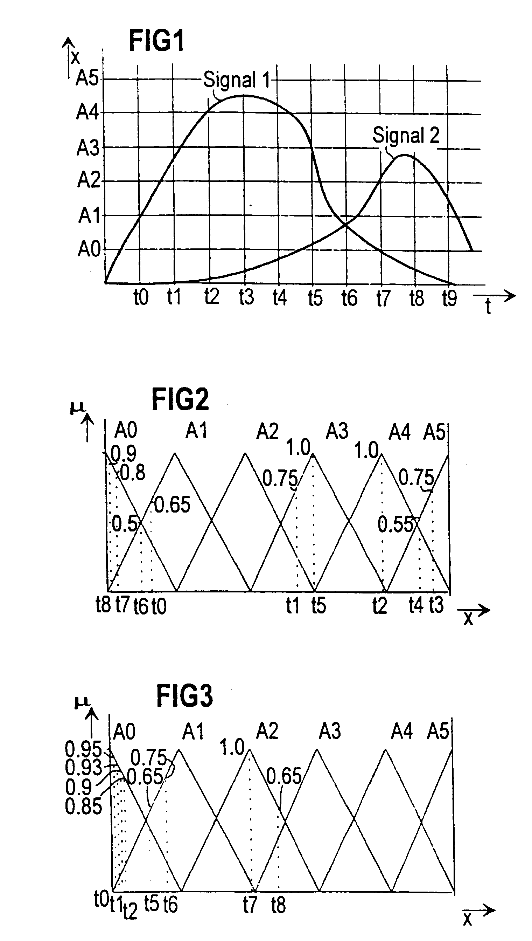

Gemäß der Erfindung wird ein auftretendes Signal zeitlich äquidistant mit den Abtastzeitpunkten t0,...,tn abgetastet und die Amplituden der Abtastwerte werden mit äquidistanten Schwellwerten A0,...,Am verglichen (siehe Figur 1). Den äquidistanten Schwellwerten A0,...,Am werden, wie es in den Figuren 2 und 3 dargestellt ist, dreiecksförmige Zugehörigkeitsfunktionen zugeordnet, die in dem betrachteten Intervall gleichverteilt sind. Dem zu identifizierenden Satz von Mustersignalen wird stets der gleiche Satz von Zugehörigkeitsfunktionen zugeordnet. Für ein ausgewähltes Mustersignal werden für die Abtastzeitwerte t0,...,tn Zugehörigkeitswerte aus den Zugehörigkeitsfunktionen für die Schwellwerte A0,...,Am bestimmt. Für jeden Abtastzeitpunkt t0,...,tn wird ein Satz von Regeln definiert, der sämtliche Mustersignale charakterisiert. Diese Regeln geben an, zwischen welchen Schwellwerten das entsprechende Mustersignal zum betrachteten Abtastzeitpunkt liegt.

In einem folgenden, sehr einfachen Beispiel wird ein solcher Regelsatz für acht Abtastzeitpunkte und zwei Signale S1 und S2 angegeben:

| | | |
|---|---|---|
| t0: | IF (A0 OR A1) THEN S1 | (0.35 OR 0.65) = 0.65 |
| | IF (A0 OR A1) THEN S2 | (0.35 OR 0.65) = 0.65 |
| | | |
| t1: | IF (A2 OR A3) THEN Sl | (0.25 OR 0.75) = 0.75 |
| | IF (AO OR A1) THEN S2 | (0.0 OR 0.0) = 0.0 |
| | | |
| t2: | IF (A3 OR A4) THEN S1 | (0.0 OR 1.0) = 1.0 |
| | IF (A0 OR A1) THEN S2 | (0.0 OR 0.0) = 0.0 |
| | | |
| t3: | IF (A4 OR A5) THEN S1 | (0.25 OR 0.75) = 0.75 |
| | IF (A0 OR A1) THEN S2 | (0.0 OR 0.0) = 0.0 |
| | | |
| t4: | IF (A4 OR A5) THEN S1 | (0.45 OR 0.55) = 0.55 |
| | IF (A0 OR A1) THEN S2 | (0.0 OR 0.0) = 0.0 |
| | | |
| t5: | IF (A2 OR A3) THEN S1 | (0.0 OR 1.0) = 1.0 |
| | IF (A0 OR A1) THEN S2 | (0.0 OR 0.0) = 0.0 |
| | | |
| t6: | IF (A0 OR A1) THEN S1 | (0.5 OR 0.5) = 0.5 |
| | IF (A0 OR A1) THEN S2 | (0.5 OR 0.5) = 0.55 |
| | | |
| t7: | IF (A0 OR A1) THEN S1 | (0.8 OR 0.2) = 0.8 |
| | IF (A1 OR A2) THEN S2 | (0.2 OR 0.0) = 0.2 |
| | | |
| t8 : | IF (A0 OR A1) THEN S1 | (0.9 OR 0.1) = 0.65 |
| | IF (A2 OR A3) THEN S2 | (0.0 OR 0.0) = 0.0 |

Ein unbekanntes Signal wird dann dadurch klassifiziert, daß die Stärke für jede Regel durch Fuzzifizierung der Amplitudenwerte festgestellt wird und daß für jede signalklasse die mittlere Stärke berechnet wird.

In unserem kleinen Beispiel ergibt sich für

| | |
|---|---|
| S1: | (0.65+0.75+1.0+0.55+1.0+0.5+0.8+0.65)/8 = 0.831 |
| | |
| S2: | (0.65+0.55+0.2)/8 = 0.175 |

Ein unbekanntes Signal wird derjenigen Signal klasse zugeordnet, für die die höchste Zugehörigkeit erreicht ist.

## Patentansprüche

1. Verfahren zur Erkennung von Signalen mittels Fuzzy-Klassifikation mit folgenden Schritten:
a) der Signalamplitudenwertebereich wird in einzelne diskrete Schwellenamplitudenwerte (A0,...,A5) unterteilt;
b) für jeden diskreten Amplitudenwert wird eine Zugehörigkeitsfunktion derart definiert, daß eine jede ihre jeweilige maximale Zugehörigkeit im jeweiligen diskreten Amplitudenwert (A0,...A5) hat;
c) mindestens ein erstes Referenzmuster eines zu erkennenden ersten Signales (Signal 1) wird zeitlich äquidistant (t0,...t9) abgetastet, wobei zu jedem Abtastzeitpunkt (t0,...t9) eine erste Referenzsignalamplitude ermittelt wird;
d) für mindestens jede erste Referenzsignalamplitude wird zu jedem Abtastzeitpunkt eine erste Zuordnungsregel definiert, welche angibt innerhalb welches Intervalles von zwei genau bezeichneten unmittelbar benachbarten Schwellenamplitudenwerten die erste Referenzamplitude (A) sich zum jeweiligen Abtastzeitpunkt (t) befindet,
e) ein zu erkennendes Signal (Signal 2) wird identisch wie das Referenzmuster zeitlich äquidistant abgetastet, wobei zu jedem Abtastzeitpunkt eine Erkennungssignalamplitude ermittelt wird;
f) für die jeweiligen Erkennungssignalamplituden werden die Zugehörigkeitswerte zu den Zugehörigkeitsfunktionen der diskreten Amplitudenwerte bestimmt;
g) die Zugehörigkeitswerte werden mit den Zuordnungsregeln als Fuzzy-Regeln ausgewertet, und für die jeweiligen Regeln wird deren Stärke bestimmt;
h) die Stärken sämtlicher zu einem jeweiligen Referenzmuster gehörenden Fuzzyregeln werden aufaddiert und daraus das arithmetische Mittel als Bewertungsmaß gebildet;
i) das zu erkennende Signal wird als erstes Signal erkannt, sofern das Bewertungsmaß größer als 0,5 ist.

2. Verfahren nach Anspruch 1, bei dem mindestens zwei zu erkennende Signale (Signal 1, Signal 2) erkannt werden, indem für das jeweilige Signal Zuordnungsregeln definiert werden.

3. Verfahren nach einem der vorangehenden Ansprüche bei dem die Zugehörigkeitsfunktionen auf 1 normiert werden.

4. Verfahren mach einem der vorangehenden Ansprüche, bei dem dreiecksförmige Zugehörigkeitsfunktionen verwendet werden.

## Claims

1. Method for detecting signals by means of fuzzy-logic classification, having the following steps:
a) the range of signal amplitude values is subdivided into individual discrete threshold amplitude values (A0,...A5);
b) a membership function is defined for each discrete amplitude value in such a way that each has its respective maximum membership in the respective discrete amplitude value (A0,...A5);
c) at least one first reference pattern of a first signal to be detected (signal 1) is sampled equidistantly in time (t0,...t9), a first reference signal amplitude being determined at each sampling instant (t0,...t9);
d) at each sampling instant, there is defined for at least each first reference signal amplitude a first assignment rule which specifies within which interval of two precisely designated directly neighbouring threshold amplitude values the first reference amplitude (A) is located at the respective sampling instant (t),
e) a signal to be detected (signal 2) is sampled equidistantly in time in a fashion identical to the reference pattern, a detection signal amplitude being determined at each sampling instant;
f) for the respective detection signal amplitudes, the membership values are determined in relation to the membership functions of the discrete amplitude values;
g) the membership values are evaluated using the assignment rules as fuzzy-logic rules, and their strength is determined for the respective rules;
h) the strengths of all the fuzzy-logic rules belonging to a respective reference pattern are added up and the arithmetic mean is formed therefrom as a measure of evaluation;
i) the signal to be detected is detected as first signal if the measure of evaluation is larger than 0.5.

2. Method according to Claim 1, in which at least two signals to be detected (signal 1, signal 2) are detected by defining assignment rules for the respective signal.

3. Method according to one of the preceding claims, in which the membership functions are normalized to 1.

4. Method according to one of the preceding claims, in which triangular membership functions are used.

## Revendications

1. Procédé d'identification de signaux par classification en logique floue comportant les étapes suivantes:
a) la plage des valeurs d'amplitude des signaux est divisée en valeurs d'amplitude de seuil individuelles discrètes (A0,...,A5);
b) une fonction d'appartenance est définie pour chaque valeur d'amplitude discrète de sorte que chacune dispose de sa propre appartenance maximale dans la valeur d'amplitude discrète correspondante (A0,...A5);
c) au moins un premier modèle de référence d'un premier signal à identifier (signal 1) est échantillonné de manière équidistante dans le temps (t0,...t9), une première amplitude de signal de référence étant déterminée à chaque moment fixé d'échantillonnage (t0,...t9);
d) pour au moins chaque première amplitude de signal de référence, une première règle d'affectation est définie pour chaque moment fixé d'échantillonnage, laquelle indique à l'intérieur de quel intervalle de deux valeurs d'amplitude de seuil directement voisines et désignées avec précision la première amplitude de référence (A) se trouve par rapport au moment fixé d'échantillonnage (t) correspondant,
e) un signal à identifier (signal 2) est échantillonné de manière équidistante dans le temps comme pour le modèle de référence, une amplitude de signal d'identification étant déterminée pour chaque moment fixé d'échantillonnage;
f) les valeurs d'appartenance aux fonctions d'appartenance des valeurs d'amplitude discrètes sont déterminées pour les amplitudes de signaux d'identification correspondants.
g) les valeurs d'appartenance sont évaluées avec les règles d'attribution comme règles floues et leur puissance est déterminée pour les règles correspondantes;
h) les puissances de toutes les règles floues appartenant à un modèle de référence correspondant sont additionnées et leur moyenne arithmétique est formée à partir de celles-ci comme critère d'évaluation;
i) le signal à identifier est identifié comme premier signal, dans la mesure où le critère d'évaluation est supérieur à 0,5.

2. Procédé selon la revendication 1, dans lequel au moins deux signaux à identifier (signal 1, signal 2) sont identifiés, dans lequel des règles d'attribution sont définies pour le signal correspondant.

3. Procédé selon l'une des revendications précédentes, dans lequel les fonctions d'appartenance sont normalisées à 1.

4. Procédé selon l'une des revendications précédentes, dans lequel des fonctions d'appartenance triangulaires sont utilisées.
